# EUROPEAN PATENT APPLICATION

(11) **EP 4 621 462 A2**
(43) Date of publication of application: **24.09.2025**
(21) Application number: 25164614.7
(22) Date of filing: 19.03.2025
(51) Int. Cl.: G02B 6/42, G02B 6/43

(54) **SYSTEM AND METHODS FOR BACKSIDE POWER DELIVERY FOR PACKAGES**

(30) Priority: 20.03.2024 US 202463567894 P; 07.03.2025 US 202519073005
(71) Applicant: Samsung Electronics Co., Ltd., Suwon-si, Gyeonggi-do 16677 (KR)
(72) Inventor: LI, Yan, San Jose, CA, 95134 (US); KIM, WooPoung, San Jose, CA, 95134 (US)
(74) Representative: Kuhnen & Wacker Patent- und Rechtsanwaltsbüro PartG mbB

(57) **Abstract**

Disclosed herein are methods, systems and devices including a substrate (101) having a first attachment location and a second attachment location, a first photonic integrated circuit (108) positioned within the first attachment location, a first connecting element (350) positioned within the second attachment location, and a first multi-device package (102) positioned on the substrate at least partially over the first attachment location and the second attachment location. In some embodiments, a second multi-device package (302) may be positioned on the substrate at least partially over the second attachment location and electrically connected to the first multi-device package (102) by the first connecting element (350).

## Description

### TECHNICAL FIELD

The subject matter disclosed herein relates to microelectronics packaging and integrated circuits (IC) packaging. More particularly, the subject matter disclosed herein relates to a technique for connecting between electronic integrated circuits (EICs) and photonic integrated circuits (PICs) using backside power delivery networks.

### BACKGROUND

Semiconductor devices may connect to additional devices and circuitry on different substrates. Forming connections between substrates can provide increased computation. However, forming connections between substrates can cause complications. Packaging describes the general method for connecting and integrating multiple computational components together in an integrated unit, and may involve multiple different types of integrated circuits on multiple substrates which may combine into a single unit. Packaging may also describe the method for which multiple computational components within a single unit are protected by the use of various techniques to provide thermal, physical and electrical protection. Background concepts discussed herein are for informational purposes only and are not intended to limit the present disclosure. Nor should the background or field described herein be intended to limit the disclosure herein to a particular use or concept.

### SUMMARY

An example embodiment provides a device including a substrate having a first attachment location and a second attachment location, a first photonic integrated circuit positioned within the first attachment location, a first connecting element positioned within the second attachment location, and a first multi-device package positioned on the substrate at least partially over the first attachment location and the second attachment location. In some embodiments, a second multi-device package may be positioned on the substrate at least partially over the second attachment location and electrically connected to the first multi-device package by the first connecting element. In some embodiments, the first multi-device package includes at least one of a memory device and a processing device. In some embodiments, a redistribution layer is arranged between the first photonic integrated circuit and the first multi-device package, and an optical fiber connection may extend between a surface of the substrate and the first photonic integrated circuit. In some embodiments, the substrate is a glass substrate or may be a silicon substrate. In some embodiments, the first photonic integrated circuit includes a connector able to receive a bi-directional optical fiber, the bi-directional optical fiber able to transmit an incoming optical signal to the first photonic integrated circuit and transmit an outgoing optical signal from the first photonic integrated circuit. In some embodiments, a fluid cooling channel may be formed within the substrate, with a heat conduit formed between the first attachment location and a surface of the substrate, and the heat conduit may thermally couple the first photonic integrated circuit to the fluid cooling channel. In some embodiments, an electronic integrated circuit may be arranged between the first photonic integrated circuit and the substrate.

An example embodiment provides a system with a substrate having a first side, the first side having a first attachment location and a second attachment location. A photonic integrated circuit may be at least partially within the first attachment location. A first connecting element may be at least partially within the second attachment location. A first multi-device package may be positioned on the first side of the substrate. A first heat conduit may be within the substrate and may extend from the second side of the substrate to the first attachment location. A second multi-device package may be positioned on the first side of the substrate and may be coupled to the first multi-device package via the first connecting element, with the first connecting element at least partially within the second attachment location. An attachment layer may be between the first heat conduit and the photonic integrated circuit. A second heat conduit may be within the substrate, and extend from the second side of the substrate to the second attachment location, and an attachment layer may be between the second heat conduit and the first connecting element. A fluid cooling channel may be located within the substrate and thermally coupled to the first heat conduit. A redistribution layer may be arranged between the photonic integrated circuit and the first multi-device package, and an optical fiber connection may extend between a surface of the first side of the substrate and a surface of the photonic integrated circuit parallel to the first side. The first multi-device package may be positioned at least partially over the first attachment location and the second attachment location.

An example embodiment provides a method including forming a first attachment location and a second attachment location within a first side of a substrate, positioning a photonic integrated circuit at least partially within the first attachment location, positioning a first connecting element at least partially within the second attachment location, forming a redistribution layer on the first side of the substrate, forming an opening in the redistribution layer over the photonic integrated circuit, positioning a first multi-device package on the redistribution layer, the first multi-device package electrically connected to the photonic integrated circuit and the first connecting element, positioning a second multi-device package on the redistribution layer, the second multi-device package electrically connected to the first multi-device package via the first connecting element, and connecting an optical fiber to the photonic integrated circuit via the opening in the redistribution layer. In some embodiments, the substrate may be prepared by forming at least one of a heat conduit, a liquid cooling channel and a through-substrate via. In some embodiments, the optical fiber connects to a surface of the photonic integrated circuit parallel to the first side of the substrate. In some embodiments, the first multi-device package includes at least one of a processing device and a memory device. In some embodiments, forming the first attachment location and the second attachment location within the first side of the substrate may be done by laser milling a glass substrate.

### BRIEF DESCRIPTION OF THE DRAWING

In the following section, the aspects of the subject matter disclosed herein will be described with reference to exemplary embodiments illustrated in the figures, in which:
FIG. 1A depicts a cross-section view of an example embodiment of a hybrid electronic integrated circuit and photonic integrated circuit according to various embodiments of the subject matter disclosed herein;
FIG. 1B depicts an enlarged cross-section view of an example embodiment of a hybrid electronic integrated circuit and photonic integrated circuit according to various embodiments of the subject matter disclosed herein;
FIG. 1C depicts a plan view of an example embodiment of a hybrid electronic integrated circuit and photonic integrated circuit according to various embodiments of the subject matter disclosed herein;
FIG. 2 depicts a cross-section view of an example embodiment of a hybrid electronic integrated circuit and photonic integrated circuit according to various embodiments of the subject matter disclosed herein;
FIG. 3A depicts a cross-section view of an example embodiment of a hybrid electronic integrated circuit and photonic integrated circuit according to various embodiments of the subject matter disclosed herein;
FIG. 3B depicts a plan view of an example embodiment of a hybrid electronic integrated circuit and photonic integrated circuit according to various embodiments of the subject matter disclosed herein;
FIG. 4 depicts a cross-section view of an example embodiment of a hybrid electronic integrated circuit and photonic integrated circuit according to various embodiments of the subject matter disclosed herein;
FIG. 5A depicts a cross-section view of an example embodiment of a hybrid electronic integrated circuit and photonic integrated circuit according to various embodiments of the subject matter disclosed herein;
FIG. 5B depicts a plan view of an example embodiment of a hybrid electronic integrated circuit and photonic integrated circuit according to various embodiments of the subject matter disclosed herein;
FIG. 6 depicts a cross-section view of an example embodiment of a hybrid electronic integrated circuit and photonic integrated circuit according to various embodiments of the subject matter disclosed herein;
FIG. 7A depicts a cross-section view of an example embodiment of a hybrid electronic integrated circuit and photonic integrated circuit assembly at a first time according to various embodiments of the subject matter disclosed herein;
FIG. 7B depicts a cross-section view of an example embodiment of a hybrid electronic integrated circuit and photonic integrated circuit assembly at a second time according to various embodiments of the subject matter disclosed herein;
FIG. 7C depicts a cross-section view of an example embodiment of a hybrid electronic integrated circuit and photonic integrated circuit assembly at a third time according to various embodiments of the subject matter disclosed herein;
FIG. 7D depicts a cross-section view of an example embodiment of a hybrid electronic integrated circuit and photonic integrated circuit assembly at a fourth time according to various embodiments of the subject matter disclosed herein;
FIG. 7E depicts a cross-section view of an example embodiment of a hybrid electronic integrated circuit and photonic integrated circuit assembly at a fifth time according to various embodiments of the subject matter disclosed herein;
FIG. 7F depicts a cross-section view of an example embodiment of a hybrid electronic integrated circuit and photonic integrated circuit assembly at a sixth time according to various embodiments of the subject matter disclosed herein;
FIG. 7G depicts a cross-section view of an example embodiment of a hybrid electronic integrated circuit and photonic integrated circuit assembly at a seventh time according to various embodiments of the subject matter disclosed herein;
FIG. 7H depicts a cross-section view of an example embodiment of a hybrid electronic integrated circuit and photonic integrated circuit assembly at an eighth time according to various embodiments of the subject matter disclosed herein;
FIG. 8 depicts an example embodiment of a method of forming a package structure according to various embodiments of the subject matter disclosed herein;
FIG. 9 depicts a cross-section view of an example embodiment of a hybrid electronic integrated circuit and photonic integrated circuit assembly according to various embodiments of the subject matter disclosed herein;
FIG. 10 depicts a cross-section view of an example embodiment of a hybrid electronic integrated circuit and photonic integrated circuit assembly according to various embodiments of the subject matter disclosed herein;
FIG. 11 depicts a cross-section view of an example embodiment of a hybrid electronic integrated circuit and photonic integrated circuit assembly according to various embodiments of the subject matter disclosed herein;
FIG. 12 depicts a cross-section view of an example embodiment of a hybrid electronic integrated circuit and photonic integrated circuit assembly according to various embodiments of the subject matter disclosed herein;
FIG. 13 depicts a cross-section view of an example embodiment of a hybrid electronic integrated circuit and photonic integrated circuit assembly according to various embodiments of the subject matter disclosed herein;
FIG. 14 depicts a cross-section view of an example embodiment of a hybrid electronic integrated circuit and photonic integrated circuit assembly according to various embodiments of the subject matter disclosed herein; and
FIG. 15 depicts a cross-section of an example embodiment of a hybrid electronic integrated circuit and photonic integrated circuit assembly according to various embodiments of the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Integrated Chip," "First Substrate," "PIC" etc.) may be interchangeably used with a corresponding non-capitalized version (e.g., "integrated chip," "first substrate," "pic," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein electronic integrated circuits, or EICs, may refer to a wide variety of integrated circuits using electrical components. In some embodiments, EICs may include a combination of various electrical components such as transistors, resistors, inductors, and capacitors which in combination form an electronic circuit on a substrate. In some embodiments, EICs may include central processing units (CPUs), logic chips, memory such as static random-access memory (SRAM), dynamic random-access memory (DRAM), synchronous dynamic random-access memory (SDRAM), double data rate DRAM or DDR DRAM, application processors (AP), auxiliary processing units (XPUs), graphical processing units (GPUs), other forms of auxiliary processing units (xPU), artificial intelligence (AI) chips, high bandwidth memory (HBM) interfaces, and other application-specific integrated circuits

(ASIC). In some embodiments, a combination of circuits may be present on a substrate. In some embodiments, EICs may be referred to in terms such as microchips, microcontrollers, silicon chips. As used herein, an XPU may refer to an auxiliary processing unit designed to perform specialized or dedicated processing optimized for conducting specific tasks more efficiently than a general processing unit such as a CPU, and may be also referred to as a data processing unit (DPU), infrastructure processing unit (IPU), function accelerator card (FAC), network attached processing unit (NAPU).

As used herein photonic integrated circuits, or PICs, may refer to a wide variety of integrated circuits using photonic components. In some embodiments, PICs may include a combination of various photonic components such as waveguides, optical filters, gratings, lenses, mirrors, and optical ring resonators. In some embodiments, PICs may include electrical components such as photodiodes, light emitting diodes, and laser diodes. In some embodiments, PICs may be referred to using terms such as integrated optical circuits, and planar light wave circuits.

As used herein substrates may refer to a variety of materials and structures, including wafers using silicon, wafers using silicon on an insulator (SOI) such as glass, wafers of other semiconductor materials such as germanium, as well as other semiconductor materials on an insulator. In some embodiments, a substrate may include an organic material. In some embodiments, the substrates may be referred to as wafers, dies, and chips alone or in combination. Bonding substrates may be thus known in some embodiments as die-to-die (D2D) bonding, wafer-to-wafer bonding (W2W) or die-to-wafer bonding (D2W). In some embodiments, a packaged chip may contain multiple substrates, and may include PIC substrates, EIC substrates, or a combination of PIC substrates and EIC substrates.

As used herein packaging refers to a process of forming interconnections between substrates. In some embodiments, the interconnections may be between direct surfaces and involve W2W, D2D, and D2W bonding. In other embodiments, techniques including wire bonding and other forms of indirect bonding may be performed alone or in combination with W2W, D2D, and D2W bonding. In some embodiments, circuits may be bonded directly facing each other, while in other embodiments a flip-chip bonding may be used. In some embodiments, interconnections may be made between substrates on a front or circuit side of the substrate. In other embodiments, interconnections may be made on a rear or back side of the substrate opposite from the circuit structure. In some embodiments, an interconnection may include through-silicon vias (TSVs), through-glass vias (TGVs) or other forms of through-chip vias where one or more substrates may be electrically connected using a via traveling through an interposer such as another substrate or chip. In some embodiments, an interconnection may be formed using connections on a surface of a substrate, such as a pad, and may use additional materials between the pads such as solder to form an interconnection.

In some embodiments, bonding between substrates may involve bonding between metals, or metal-metal bonding. In some embodiments, bonding between substrates may involve bonding between dielectric materials, or dielectric-dielectric bonding. In some embodiments, bonding between substrates may involve both metal-metal and dielectric-dielectric bonding, known as hybrid bonding. A hybrid bonding technique may be used to provide additional connections between opposing surfaces, allowing both dielectric and conductive surfaces to bond, and may increase the mechanical strength of the resulting structure.

As used herein multiplexing may refer to a number of techniques for multiplexing optical signals. In some embodiments, multiplexing may refer to wavelength division multiplexing (WDM). In some embodiments, the multiplexing may refer to polarization-based multiplexing. In some embodiments, the multiplexing may refer to optical fiber mode based polarization. In some embodiments, multiplexing may be a combination of one or more of WDM, polarization, and fiber mode polarization.

As used herein, polarization may refer to both linear and circular polarization. Linear polarization modes may be referred to as S and P or transverse-magnetic (TM) and transverse-electric (TE) polarizations. Circular polarizations may be referred to as right-handed polarization (RCP) or left-handed polarization (RCP).

As used herein, conductors may refer to a variety of conductive materials, including which materials may be used alone or in combination with other materials such as in the form of an alloy. In some embodiments the conductor is copper (Cu). In some embodiments, copper (Cu) may be in the form of Cu (II), Cu (III) or other forms of copper, alone or in combination with additional elements, including cobalt (Co) and ruthenium (Ru). Such a listing of elements is not intended to be exhaustive, and in other embodiments, any known other type of conductive material may be used.

As used herein, a device stack or stack of devices may refer to a combination of memory and supporting circuit architecture, for example, chiplets and dies containing individual memory elements, supporting processing units, input output (I/O) circuitry, and other forms of integrated chips. As used herein, a chiplet may refer to an integrated circuit having a well-defined functionality, such as a microprocessor, a memory device, or other computational function; with a chiplet enabling a modular design with multiple chiplets able to be combined with a larger package, sharing a substrate or interposer to form a larger device. A core may refer to a single-unit of a multicore device where multiple devices form a larger device, with each device able to function independently to enable multiple streams of operations. In some embodiments, a core may take the form of a chiplet, or a chiplet may take the form of a core. However, in other embodiments, a chiplet may take the form of any other suitable integrated circuit. As used herein, high bandwidth memory or HBM, may refer to a chip structure including one or more HBM modules. In some embodiments, the HBM may be manufactured by an advanced silicon node process.

As used herein, a connecting element refers to a substrate, die, or other material having one or more conductive pathways able to form connection between one or more semiconductor devices, as well as substrates, interposers, or other package structures. A connecting element may include one or more traces, the traces forming a connection pathway along the connecting element between one or more devices coupled to the connecting element. An embedded connecting element, as used herein, may refer to a connecting element in a layer within a semiconductor package, and may be used interchangeably with connecting element. An active connecting element may refer to a connecting element featuring additional features beyond connections, such as transistors, vias, and other circuit components. As used herein, a connecting element may be referred to as a connector, a bridge, or a bridge arch; an active connecting element may be referred to as an active bridge, an active bridge arch, or an active connector; and an embedded connecting element may be referred to as an embedded bridge, an embedded bridge arch, or an embedded connector.

Disclosed herein are various embodiments of systems, methods and devices using co-packaging of both EICs and PICs with a support base to form a hybrid device, which may be referred to as a hybrid transceiver. The hybrid transceiver may be formed in threedimensions by stacking dies on a support base. The support base may be positioned on top of a supporting substrate, also referred to as the core substrate, which may be a glass core substrate, a silicon substrate, or a substrate formed of any other suitable semiconductor material. The support base may include one or more layers to transmit electrical signals and power between the support base and one or more compute devices positioned on the support base. A connecting element, also referred to as a bridge, may be used to couple compute devices between multiple support bases. In some embodiments, the connecting element may be formed within the supporting substrate, while in other embodiments, the connecting element may be formed on top of the supporting substrate. In some embodiments, an EIC may be formed within the support base, while in other embodiments an EIC may be formed on or within the supporting substrate.

In some embodiments, the EIC may take the form of one or more compute devices positioned on top of the support base, the one or more compute devices including compute devices such as memory devices, processing devices such as XPUs, ASICs, and stacks including combinations such as HBMs. The PIC may, in some embodiments, form a transceiver for receiving and transmitting optical signals for the hybrid transceiver. The PIC may use a v-groove configuration to allow positioning optical communications fibers to the PIC. In some embodiments, the PIC may have one or more through-substrate vias (TSVs) allowing signals to travel through the PIC to devices positioned on either side of the PIC. In some embodiments, the supporting substrate may further include one or more TSVs or TGVs.

Disclosed herein are various embodiments of devices, systems and methods related to packaging architecture to modularly create a package architecture providing a device stack with integrated modules having backside power delivery networks. A device stack architecture may include the support base providing logic, routing, and power delivery to one or more compute devices mounted upon the support base. Power and signals to the compute devices may be routed via the support base. In some embodiments, the one or more connecting elements may take the form of ASIC devices which may perform functions such as logic, routing, and power management for the device stack.

A back-side power delivery network (BSPDN), also referred to as a power layer, may be formed on the back side of the support base, with a signal network layer formed on the front side of the same support base. In some embodiments, the BSPDN and signal network layer may be formed on separate substrates and transferred to the same support base. The BSPDN and signal network layer may be separated by a transistor layer. The transistor layer may include a plurality of transistors and may provide different functions and take different forms, including a logic layer, processors, capacitors, memory, and an ASIC device. The BSPDN, support circuit, and signal network layer may form a single monolithic structure on the same die in a semiconductor foundry process. A stacked device module may separately be formed in a semiconductor foundry process, the same semiconductor foundry process, or may have multiple components formed in multiple semiconductor foundry processes and assembled in a packaging assembly process. In some embodiments, multiple support bases may be formed on the same supporting substrate, and may each have their own BSPDN and signal networks.

As disclosed herein, in some embodiments, the connecting elements between devices may be active connecting elements, with the connecting element including one or more additional circuit elements such as transistors, vias, and other circuit components, such as capacitors, resistors, or any other suitable circuit elements. In some embodiments, an active connecting element may include a logic unit to provide a routing interface between one or more device stacks. In some embodiments, a connecting element may include an ASIC device. In some embodiments, a connecting element may be formed on top of the support base between one or more compute devices.

In some embodiments, multiple device stacks may be mounted on a supporting substrate. The supporting substrate may be any appropriate substrate, including substrates made from organic materials, silicon, silicon core substrates, as well as glass substrates. some embodiments, within the supporting substrate additional devices and components may be formed, for example additional compute devices, logic devices, routing, power delivery and communication routing may be formed on the supporting substrate.

In some embodiments, a hybrid transceiver may be formed using a core substrate such as a glass core or silicon core substrate. The core substrate may have thermal features such as heat conduits and liquid cooling channels formed within. One or more TSV may also be formed on and within the core substrate. One or more cavities may then be formed within the core substrate for the placement of one or more PIC, one or more EIC, and additional elements such as connecting elements, capacitors, etc. Prior to placing any elements within the core substrate, an attachment layer may be formed within the cavity to provide a good connection between the elements and the core substrate. In some embodiments, a cavity may be referred to as an attachment location. After placing the elements such as PICs and EICs within the core substrate, one or more redistribution layers may be formed on the surfaces of the core substrate, and may cover the now embedded elements within the core substrate. The redistribution layers may be subject to additional processing to create interconnections such as bumps and vias, as well as to create an opening allowing access to optical elements such as the PIC. Upon the redistribution layers, a support base may be placed and coupled to the PIC within the core substrate. The support base may support one or more stacks of compute devices, which may be coupled to the support base prior to the support base being placed upon the redistribution layer. The support base and the one or more stacks of compute devices may be referred to collectively as a multi-stack device or a multi-device package. Within the open area or opening formed in the redistribution layer, one or more optical connecting elements may be further connected to the PIC embedded within the core substrate.

As used herein, a power layer may refer to one or more layers of conductive material forming pathways in a dielectric material to provide electrical power to the various devices and components connected to the power layer. The power layer may provide a power delivery network for routing power supply lines on a back side of a transistor layer and may provide both power and reference voltages to transistors in the transistor layer. A signal network layer may refer to one or more layers of conductive material forming pathways in a dielectric material to provide communications signals to the various devices and components connected to the signal network layer. In some embodiments, the signal network layer may be referred to as the signal layer. The signal network layer may provide the signal routing between the transistor layer and the one or more compute devices, including communications signals.

As used herein, a redistribution layer may refer to one or more individual layers including one or more conductive materials such as a series of pads, bumps, vias, through-vias, traces, and other forms of connection for redistributing signals across the layer. In some embodiments, redistribution layers may be used to connect different components spread across a device package, allowing signals and power to transfer laterally across the redistribution layers. Redistribution layers may allow for indirect coupling between connections on adjacent layers by providing additional routes for the signals to transfer laterally as well as vertically.

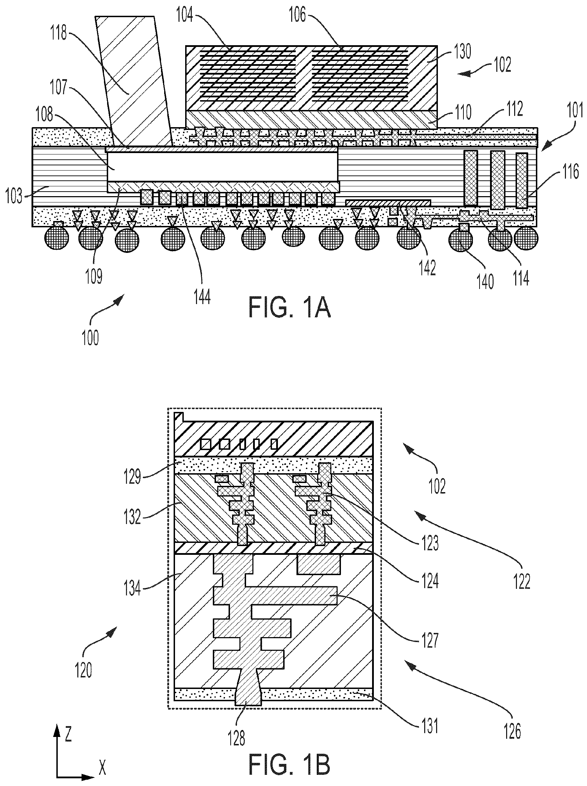

FIG. 1A depicts a cross-sectional view of an exemplary embodiment of a first device package architecture 100. The first device package architecture 100, which may be referred to as a hybrid transceiver, includes a supporting substrate 101 with a first multi-device package 102 mounted on the supporting substrate 101. The first multi-device package 102 includes a first compute device 104, a second compute device 106 within a first encapsulation layer 130 and mounted on a support base 110. The support base 110 is shown in further detail within an enlarged cross-section 120 in FIG. 1B and further discussed below. The supporting substrate 101 includes a core substrate 103 with an upper RDL 112 formed on top of the core substrate 103 and a lower RDL 114 formed on the bottom of the core substrate 103. The support base 110 may couple to the supporting substrate 101 via the upper RDL 112. A first PIC 108 may be embedded within the core substrate 103, and coupled to the first multi-device package 102 via the upper RDL 112. One or more TSVs 116 may couple the upper RDL 112 to the lower RDL 114.

In some embodiments, the compute devices including the first compute device 104 and the second compute device 106 may include a die, a core, or chiplet, or any other suitable form of circuit. As used herein, a chiplet may refer to an integrated circuit having a well-defined functionality, such as a microprocessor, a memory device, or other computational function; with a chiplet enabling a modular design with multiple chiplets able to be combined with a larger package, sharing a substrate or interposer to form a larger device. In some embodiments, the compute devices may be various forms of memory including DRAM, SRAM, and other forms of memory. In some embodiments, the devices may include a core device, for example a processor, processing device, or other form of microcontroller to act as a controller. A core may refer to a single-unit of a multicore device where multiple devices form a larger device, with each device able to function independently to enable multiple streams of operations. In some embodiments, a core may take the form of a chiplet, or a chiplet may take the form of a core. However, in other embodiments, a chiplet may take the form of any other suitable integrated circuit. In some embodiments, a single compute device may be used, while in other embodiments, additional compute devices may be added, for example 4, 6, 8, 16 or 32 compute devices may be added. In some embodiments, each compute device may be a single device, while in other embodiments, each compute device may be multiple devices stacked on top of each other, such as in HBM.

Additionally, the first encapsulation layer 130 may surround the first compute device 104 and the second compute device 106, and at least a portion of the support base 110. The first encapsulation layer 130 may be a dielectric material such as silicon nitride (Si₃N₄) or silicon dioxide (SiO₂). In some embodiments, the first encapsulation layer 130 may provide mechanical support, such as holding the devices in places, as well as may provide electrical isolation, and may provide a thermal path for heat from the compute devices to transfer via. In some embodiments, the first encapsulation layer 130 may be an epoxy molding compound or resin. The first encapsulation layer 130 may, in some embodiments, comprise one or more encapsulation layers, and may include individual encapsulation layers to encapsulate the first compute device 104 and the second compute device 106.

The first PIC 108 may take the form of one or more layers of optical components provided upon an optical substrate, for example glass, polymer, and silicon oxide. In some embodiments, one or more buried oxide layers (or BOX layers) may be formed upon an optical substrate and contain various photonic device components, which may be referred to as the active layer 107. The first PIC 108 may, in some embodiments, include components for modulating the optical signals such as micro-ring resonators, serializers, phase shifters, couplers, lenses, polarizers, gratings, anti-reflection coatings, filters, index matching coatings, mirrors, delay lines, and a variety of other photonic elements both passive and active. An optical signal may, in some embodiments, be generated from an external source and provided to the first PIC 108, while in other embodiments the first PIC 108 may include a light generation source such as a laser comb source such as a four-wave-mixing-based frequency comb, a Kerr frequency comb, or any other suitable technique for generating a comb signal. As used herein, a comb signal refers to an optical signal having a plurality of wavelengths separated into discrete spectra. The photonic components of the first PIC 108 may modulate, redirect, combine, separate and otherwise modify an optical signal within the first PIC 108. In some embodiments, the first PIC 108 may include one or more layers of electrical components, and in some embodiments may provide a bridge connecting the first compute device 104 and an EIC. In some embodiments, the first PIC 108 may include additional electronic circuitry, such as a logic structure for routing electrical signals from the first PIC 108 to the rest of the first device package architecture 100.

In some embodiments, the first compute device 104 may provide the driving electronics for first PIC 108, including heater control circuits, heater drivers, modulator drivers, and serializers to modify the optical signal within the first PIC 108. For example, if the first PIC 108 includes one or more micro-ring resonators, heaters may be integrated with the one or more micro-ring resonators to provide control over the resonance frequency of the one or more micro-ring resonators by altering the physical characteristics of the one or more micro-ring resonators. While portions of the heaters may be formed within the first PIC 108, the electronics controlling and regulating the heaters are within the first compute device 104 separate from the first PIC 108. Furthermore, the first PIC 108 may include one or more photodetectors to receive an optical signal, which may be transmitted to the first compute device 104 for further signal processing, including amplification, analog to digital conversion, rectification, or any other suitable signal processing techniques. In some embodiments, some or all of the driving electronics for the first PIC 108 may be transferred from the first compute device 104 to another device, such as an additional EIC which may be part of the support base 110, or may be connected via the supporting substrate 101. In some embodiments, an EIC may be integrated within the first PIC 108.

A first optical connection 118 may connect to the first PIC 108. In some embodiments, the first optical connection 118 may be a fiber optic, an optical connector, a pluggable optical connector, a plug connector, as well as combinations thereof and various arrays thereof. In some embodiments, the first optical connection 118 may include a single fiber with a single core, while in other embodiments the first optical connection may include one or more cores in one or more fibers, and may be arranged in In some embodiments, the first optical connection 118 may be unidirectional, allowing only transmitting or receiving, while in other embodiments, the first optical connection 118 may be a bi-directional fiber. In some embodiments, additional optical elements may be placed between the first optical connection 118 and the first PIC 108, such as polarizers, gratings, anti-reflection coatings, filters, index matching coatings, lenses, and any other suitable optical components, alone or in a combination thereof. In some embodiments, the first optical connection 118 may allow the first device package architecture 100 to transmit optical signals, to receive optical signals, or both receive and transmit optical signals.

In some embodiments, the first PIC 108 may couple to a plurality of optical connections, including a receiving optical connection to receive incoming optical signals, and a transmitting optical connection to transmit outgoing optical signals. In some embodiments, the plurality of optical connections may include one or more separated optical connections, the separated optical connections corresponding to one or more multiplexing methods, for example, wavelength based multiplexing, fiber mode based multiplexing, polarization based multiplexing, and combinations thereof. In some embodiments, the first optical connection 118 may provide an optical coupling for optical signals to one or more additional systems, including additional computational systems, networks, remote computers, and any other suitable optical devices.

The first optical connection 118 may optically couple to the first PIC 108 using one or more optical ports such as v-grooves coupled to one or more waveguides within the first PIC 108. As used herein, v-grooves may refer to V-shaped grooves formed within the active layer of a PIC, where the v-groove is sized to match a corresponding fiber on the first optical connection 118, which the v-groove is able to receive and transmit optical signals from the first optical connection 118 to the waveguides within the first PIC 108. In some embodiments, an optical coupler may be used to connect the first optical connection 118 to the one or more optical ports. In some embodiments, the optical coupler may be a plug connector allowing the first optical connection 118 to be removably coupled to the one or more optical ports. In other embodiments, the optical coupler may take the form of a pressurized component to secure the first optical connection 118 to the one or more optical ports, as well as take the form of an adhesive coupling the one or more optical ports and the first optical connection 118, while in further embodiments, a combination thereof may be used.

The upper RDL 112 may electrically couple to the first compute device 104, the second compute device 106, the support base 110 and the first PIC 108, as well as to one or more TSVs 116 within the supporting substrate 101. The one or more TSVs 116 within the supporting substrate 101 may electrically couple the upper RDL 112 to one or more elements positioned on or within the supporting substrate 101, as well as electrically couple the upper RDL 112 to the lower RDL 114 on the bottom of the supporting substrate 101. The lower RDL 114 may provide one or more layers including a series of pads, bumps, vias, through-vias, traces, and other forms of connection for redistributing signals from electrical connections from the supporting substrate 101 to the one or more TSVs 116, the first compute device 104, the second compute device 106, and the first PIC 108.

In some embodiments, the supporting substrate 101 may be mounted on a further substrate or card. The interconnection between the supporting substrate 101 and a further substrate may include conductive materials forming substrate interconnections 140 to electrically couple the supporting substrate 101 to the further substrate including pads, bumps, microbumps, pillars, balls, and other forms such as C4 bumps, alone or in combination. In some embodiments, a bonding layer between the supporting substrate 101 and the further substrate may include a dielectric material or an adhesive, like underfill material, to provide additional strength and connection between the supporting substrate 101 and the further substrate. In some embodiments, the interconnection may provide a metallic bonding between the supporting substrate 101 and the further substrate, a dielectric bonding between the supporting substrate 101 and the further substrate, or in some embodiments a hybrid bonding between the supporting substrate 101 and the further substrate. In some embodiments, the interconnection may bond directly with the lower RDL 114, while in other embodiments, intermediate layers may between the interconnection and the lower RDL 114.

Additionally, the supporting substrate 101 may contain one or more fluid cooling channels 142 and one or more heat conduits 144. In some embodiments, the one or more fluid cooling channels 142 may comprise a channel formed within the supporting substrate 101 for the passage of a fluid. In some embodiments, the fluid used within the one or more fluid cooling channels 142 may be a gas, such as air, nitrogen, argon, or other gas suitable for use within a semiconductor substrate. In some embodiments, the fluid used within the one or more fluid cooling channels 142 may be a liquid, such as water, aqueous solution, alcohols, glycol, and combinations thereof. In some embodiments, the one or more fluid cooling channels 142 may be formed directly in the supporting substrate 101, while in other embodiments, the one or more fluid cooling channels 142 may include one or more layers between the supporting substrate 101 and the fluid of the one or more fluid cooling channels 142. In some embodiments, the one or more layers may include a material such as a metal, ceramic, or other material to provide thermally conductive pathway between the fluid and the supporting substrate 101. In some embodiments, the one or more layers may include a material layer to provide encapsulation and protection from corrosion or other damage from a fluid.

In some embodiments, the one or more heat conduits 144 may be formed in the core substrate 103 and extend from a cavity containing the first PIC 108 to a backside surface. In some embodiments, the one or more heat conduits 144 may be one or more through-vias, such as a TSV or TGV, depending on the material of the core substrate 103. In some embodiments, the one or more heat conduits 144 may include a thermal conductive material within a through-via, such as metal like copper, silver, or aluminum, as well as additional materials suitable for use with a semiconductor process such as aluminum nitride, silicon carbide, or any other suitable thermal conductive material such as diamond, and combinations thereof. In some embodiments, the one or more heat conduits 144 may couple to additional structures for regulating heat, such as a thermal electric device, heat sinks, cooling pad, or other suitable structure. Additionally, in some embodiments, the one or more heat conduits 144 may couple with the one or more fluid cooling channels 142. In some embodiments, the one or more heat conduits 144 may contact the first PIC 108, while in other embodiments the attachment layer 109 may be between the one or more heat conduits 144 and the first PIC 108. In some embodiments, the one or more heat conduits 144 may be referred to as thermal vias.

In some embodiments, the one or more heat conduits 144 may conduct heat into a fluid of the one or more fluid cooling channels 142, and heat may be transferred away from the one or more heat conduits 144 using convective heat transfer, conductive heat transfer, or a combination thereof. In some embodiments, the fluid may be actively sent, with a mechanism such as a pump or a fan, or any other suitable method of fluid transfer, to force the flow of the fluid, while in other embodiments, the fluid path may be shaped to allow passive flow of the fluid, or use any other mechanism for passive transport, for example, using a fluid experiencing a phase change. In some embodiments, the one or more fluid cooling channels 142 may be part of a closed loop cooling system, while in other embodiments, the one or more fluid cooling channels 142 may be part of an open loop system, while in yet other embodiments, the one or more fluid cooling channels 142 may transfer between an open loop and closed loop system. In some embodiments, a heat sink, heat exchanger, expander, compressor, cooling pad, thermal cooler, or any other suitable form of cooling, and combinations thereof may be coupled to the one or more fluid cooling channels 142 to provide cooling for the fluid of the one or more fluid cooling channels 142. In some embodiments, the heat transferred via the one or more fluid cooling channels 142 may be transferred to another fluid, or may be conducted to another surface. In some embodiments, a thermal dissipation structure may be used to provide cooling using a combination of radiative, conductive, and convective heat transfer. In some embodiments, a single one of the one or more fluid cooling channels 142 may provide cooling to all of the elements embedded within the supporting substrate 101, while in other embodiments, each element may have a separate one of the one or more fluid cooling channels 142. In some embodiments, the one or more fluid cooling channels 142 may have one of the one or more fluid cooling channels 142 coupled to all of the elements embedded within the supporting substrate 101, while in other embodiments, each element embedded within the one or more fluid cooling channels 142 may have a separate one of the one or more fluid cooling channels 142 to provide relief.

FIG. 1B depicts the enlarged cross-section 120 of the support base 110 of the first device package architecture 100. Upon the top of the support base 110, and between the other elements of the support base 110 and the first compute device 104 or the second compute device 106 is the first support RDL 129. The first support RDL 129 includes a series of pads, bumps, vias, through-vias, traces, and other forms of connection for redistributing signals between the support base 110 and the first compute device 104 or the second compute device 106. The connections may take the form of a mix of conductive elements and dielectric elements suitable for bonding. The first compute device 104 and the second compute device 106 may be mounted directly to the first support RDL 129 and may have conductive elements such as leads and electrodes coupled to corresponding elements of the first support RDL 129. A portion of the first support RDL 129 may include a dielectric material suitable dielectric bonding with the first compute device 104 and the second compute device 106, as such a hybrid bond including bonding between both conductive portions and dielectric portions may be formed between the support base 110 and the first compute device 104 or the second compute device 106.

The first support RDL 129 is coupled to a signal network layer 122, which is in turn coupled to a transistor layer 124. The first support RDL 129 allows for connections between the first compute device 104 and the second compute device 106 with the support base 110 to be spread out from where lines and vias may emerge on the surface of the signal network layer 122, allowing additional space for the connections to be formed, as well as providing additional space to prevent inadvertent connections.

The signal network layer 122 may comprise a network-on-a-chip (NOC), and may provide interconnections to transport signals to and from the first compute device 104 and the second compute device 106. In some embodiments, the signal network layer 122 may provide packet routing. In some embodiments, the signal network layer 122 may be referred to as a signal network layer. In some embodiments, the signal network layer 122 may comprise a plurality of layers, including multiple layers providing signal routing. In some embodiments, the signal network layer 122 may comprise a plurality of conductive channels within a dielectric material, and the plurality of conductive channels may be arranged in multiple layers, with the size of the conductive channels decreasing in distance from the transistor layer 124. In some embodiments, the signal network layer 122 may have a plurality of conductive channels 123 and may include 15-20 signal network layer including conductive channels. In some embodiments, the plurality of conductive channels 123 may be a conductive material such as a metal, including copper. In some embodiments, the size of the conductive channels in a top layer of the signal network layer 122 may increase with size in distance from the transistor layer 124, while in other embodiments, the size of the conductive channels may be constant. The plurality of conductive channels 123 may be within a first dielectric material 132, which may take the form of a dielectric material such as silicon nitride (Si₃N₄), silicon dioxide (SiO₂), or any other suitable dielectric material for use with semiconductor processing.

The transistor layer 124 separates the signal network layer 122 from a power layer 126 and includes a plurality of transistors. As used herein, the transistor layer 124 may be used to refer to both the layer containing the plurality of transistors and the plurality of transistors themselves. In some embodiments, the transistor layer 124 may act as the base logic for both the signal network layer 122 and the power layer 126. In other embodiments, the transistor layer 124 along with the signal network layer 122 and the power layer 126 provide the base logic for the first compute device 104 or the second compute device 106. The power layer 126 provides a power delivery network for routing power supply lines 127 on the back side of the transistor layer 124 and may provide both power and reference voltages to transistors in transistor layer 124. The power layer 126 may be referred to as a backside power delivery network, and may referred to as well as a power network, power delivery network, BSPDN, or PDN. The power layer 126, as used herein refers to one or more layers of conductive material forming pathways in a dielectric material to provide electrical power to the various devices and components connected therein. In some embodiments, the power layer 126 may include multiple different layers of power supply lines 127 routing power within a second dielectric material 134. The second dielectric material 134 may take the form of a dielectric material such as silicon nitride (Si₃N₄), silicon dioxide (SiO₂), or any other suitable dielectric material for use with semiconductor processing. In some embodiments, the power layer 126 may include 4 to 6 layers of the power supply lines 127. In some embodiments, the size of the power supply lines 127 may decrease as they approach the transistor layer 124. The power supply lines 127 may be comprised of conductive materials, including various forms of low resistive metals, such as copper, alternatively or in addition, the conductive materials may include various forms of other conductive materials, including doped carbon.

In some embodiments, the transistor layer 124 may include or be a part of one or more support circuits and may provide a variety of functions for the first compute device 104 or the second compute device 106, and may include signal routing, power management, monitoring, and as well as various logic and other uses. In some embodiments, multiple support circuits may be formed within the support base 110, while in other embodiments, a single support circuit may be used with one or more additional devices, including computational devices such as memory, processors, input/output (I/O) chips, etc. as well as capacitors, and other suitable components. In some embodiments, the support circuits may take the form of an ASIC device, an EIC, or other suitable circuitry.

The second support RDL 131 forms the bottom of the power layer 126 and in some embodiments, may include a series of pads, lines, traces, and other forms of connection forming the bottom surface of the support base 110 and may couple the power layer 126 to the supporting substrate 101. In some embodiments, second support RDL 131 may further include a dielectric material, which may include a material such as an adhesive, resin, or elastomer which may form a connection between the power layer 126 and the supporting substrate 101 in addition to a conductive connection 128. In some embodiments, the combination of a conductive connection and a dielectric connection may form a hybrid bond. The supporting substrate may in turn connect to other devices and dies, and in some embodiments, may take the form of an interposer.

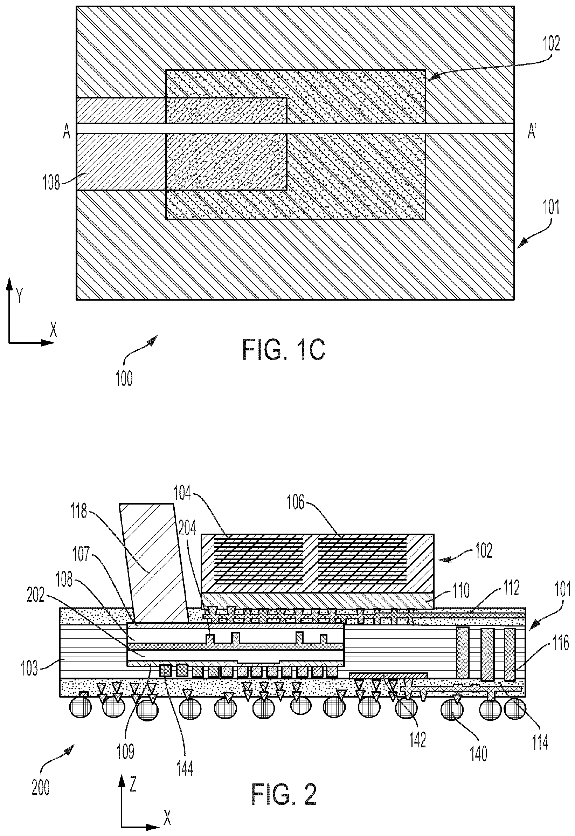

FIG. 1C depicts a plan view of the first device package architecture 100, showing the first multi-device package 102 mounted on the supporting substrate 101 and partially overlapping the first PIC 108. The view of FIG. 1C provides a plan view in the X-Y direction, while FIG. 1A and FIG 1B are along the line A-A' within the X-Z direction. The portions of the first PIC 108 extending beyond the first multi-device package 102 may be exposed to the surface for optical coupling.

FIG. 2 depicts a cross-sectional view of an example embodiment of a second device package architecture 200, which differs from the first device package architecture 100 by including an embedded EIC 202 in the supporting substrate 101. While in the first device package architecture 100, an EIC to provide control for the first PIC 108 may be formed within the first multi-device package 102, or be integrated within the first PIC 108, in the second device package architecture 200, the embedded EIC 202 is a separate structure placed underneath the first PIC 108. Signals from the embedded EIC 202 may be transferred to and from the first PIC 108 using one or more PIC vias 204, which may be a form of through-substrate vias, which connect the embedded EIC 202 to the active layer 107 of the first PIC 108. In some embodiments, an embedded redistribution layer may be formed between the embedded EIC 202 and the first PIC 108. In some embodiments, one or more additional TSV may couple the embedded EIC 202 to the first multi-device package 102, and connect via the upper RDL 112 or the lower RDL 114.

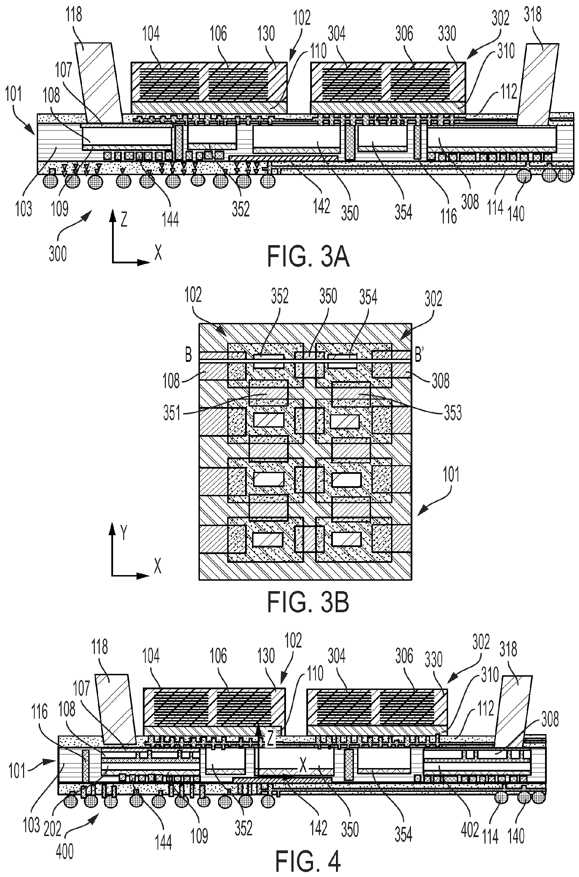

FIG. 3A depicts a cross-sectional view of an example embodiment of a third device package architecture 300, the third device package architecture 300 differing from the first device package architecture 100 of FIG. 1A-1C by including multiple sets of multi-device package, PICs, and supporting circuit elements. In the third device package architecture 300, the first multi-device package 102 is coupled with the first PIC 108 as in the first device package architecture 100. A second multi-device package 302 includes a third compute device 304, a fourth compute device 306 on a second supporting base 310 and within a second encapsulation layer 330 and mounted on a second support base 310. The second multi-device package 302 may be formed similarly to the first multi-device package 102, including the parts thereof. The second multi-device package 302 may be, like the first multi-device package 102, mounted on the upper RDL 112 to couple to a second PIC 308. The second PIC 308 may be otherwise the same as the first PIC 108, and include a second optical connection 318.

A connecting element 350 may form a connection between the first multi-device package 102 and the second multi-device package 302. The connecting element 350 may comprise a semiconductor material such as silicon, although in other embodiments different semiconductors materials such as germanium may be used. The connecting element 350 may include embedded routes which may be provided as traces, wires, buried lines, or any other known suitable method for providing a signal connection on or within a semiconductor device. In some embodiments, the connecting element 350 may include additional circuit components for routing, monitoring, and protecting signals sent via the connecting element 350, and may form a logic chip.

The connecting element 350 may provide for electrical signals to transfer between the first multi-device package 102 and the second multi-device package 302, as well as electrical signals between the first PIC 108 and the second PIC 308. In some embodiments, the first PIC 108 and the second PIC 308 may be unidirectional, with one PIC for transmitting outgoing optical signals and another for receiving incoming optical signals, with the first PIC 108 and the second PIC 308 together forming a single transceiver. In some embodiments, both the first PIC 108 and the second PIC 308 may be bi-directional transceivers, each able to receive and transmit optical signals.

In some embodiments, additional embedded support circuitry may be embedded within the supporting substrate 101. In some embodiments, additional embedded support circuitry may take the form of an integrated stack capacitor, a voltage regulator module, as well as any other suitable support circuitry. In some embodiments, the embedded support circuitry may include a first embedded module 352 and a second embedded module 354. The first embedded module 352 and the second embedded module 354 may thus provide support to the corresponding computing module for adjusting voltage, frequency, and power.

FIG. 3B depicts a plan view of the third device package architecture 300, showing the relative placement of the first multi-device package 102, the second multi-device package 302, the first PIC 108, the second PIC 308, and the connecting element 350. The view of FIG. 3B provides a plan view in the X-Y direction, while FIG. 3A provides a cross-section along the line B-B' in the X-Z direction. The portions of the first PIC 108 extending beyond the first multi-device package 102, and the portions of the second PIC 308 extending beyond the second multi-device package 302 may be exposed to the surface for optical coupling. Additionally, FIG. 3B provides an exemplary arrangement where additional multi-device package may be formed on the supporting substrate 101, with a second connecting element 351 coupling the first multi-device package 102 to a third multi-device package, while a third connecting element 353 couples the second multi-device package 302 to a fourth multi-device package. Additional rows of multi-device packages may then be formed, with FIG. 3B depicting 4 rows for a total of 8 multi-device package on the shared substrate. However, the actual number of rows may be smaller or greater than show, for example, 2, 4, 6, 10 or more rows.

FIG. 4 depicts a cross-sectional view of an example embodiment of a fourth device package architecture 400, which differs from the third device package architecture 300 by including the embedded EIC 202 in the supporting substrate 101, similarly to the second device package architecture 200. A second embedded EIC 402 is thus coupled to the second PIC 308 in a similar matter as in FIG. 2.

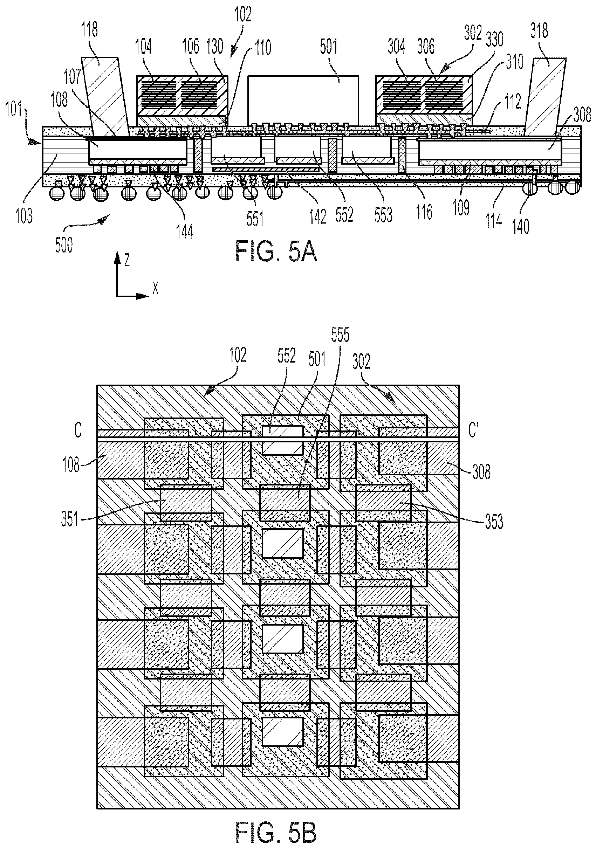

FIG. 5A depicts a cross-sectional view of an example embodiment of a fifth device package architecture 500, the fifth device package architecture 500 differing from the third device package architecture 300 of FIG. 3A-3B by using multiple connecting elements to form a center island where a supplemental compute device 501 is mounted. In FIG. 5A, a first connecting element 551 and a second connecting element 553 are embedded within the supporting substrate 101 and coupled via the upper RDL 112 to the supplemental compute device 501. In the fifth device package architecture 500, a central embedded support circuit or central embedded module 552, is used in place of the first embedded module 352 and the second embedded module 354. The supplemental compute device 501 may take the form of one or more compute devices as described above, including ASICs designed to offload functions from the compute dies.

FIG. 5B depicts a plan view of the fifth device package architecture 500, showing the relative placement of the first multi-device package 102, the second multi-device package 302, the first PIC 108, the second PIC 308, and the supplemental compute device 501. The cross-sectional view of FIG. 5A corresponds to the line C-C' in FIG. 5B. Similar to FIG. 3B, FIG. 5B provides an exemplary arrangement where additional multi-device package may be formed on the supporting substrate 101, with the second connecting element 351 coupling the first multi-device package 102 to a third multi-device package, while the third connecting element 353 couples the second multi-device package 302 to a fourth multi-device package. Additional rows of multi-device packages may then be formed, with FIG. 3B depicting 4 rows for a total of 8 multi-device package on the shared substrate. However, the actual number of rows may be smaller or greater than show, for example, 2, 4, 6, 10 or more rows. Furthermore, the supplemental compute device 501 may in turn have a supplemental connecting element 555 coupling to a second supplemental compute die, which in turn may couple to additional supplemental compute die.

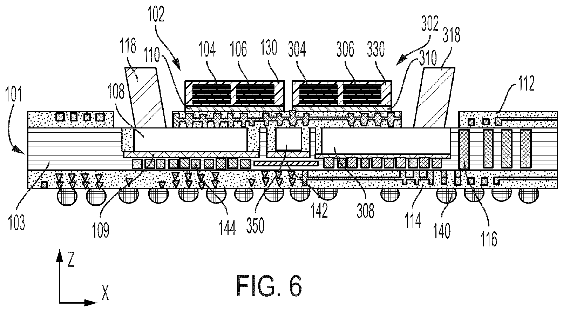

FIG. 6 depicts a cross-sectional view of an example embodiment of a sixth device package architecture 600, the sixth device package architecture 600 being a simplified version of the fourth device package architecture 400 by removing the additional support circuitry.

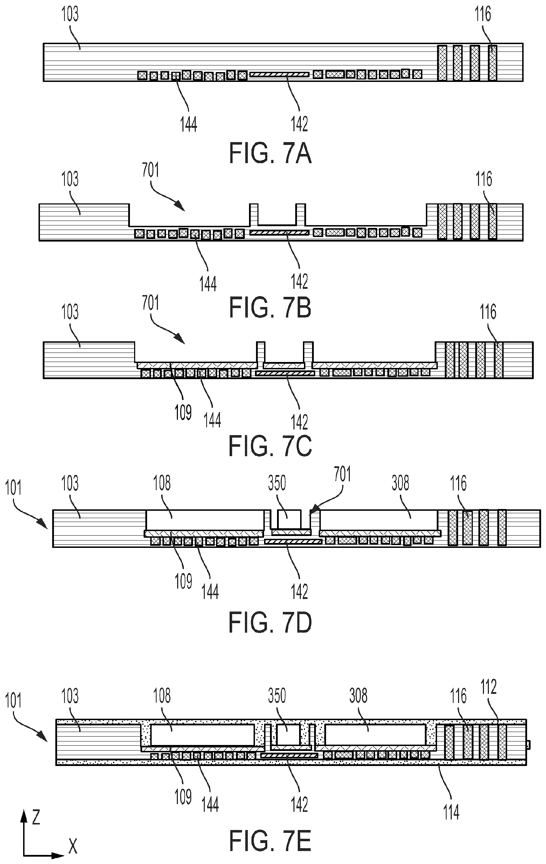

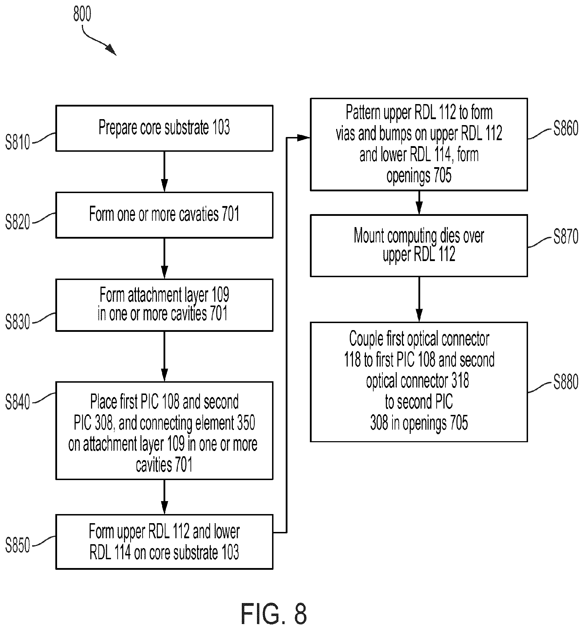

FIGS. 7A-7H depict an illustrative embodiment of a process of forming a device package architecture such as the first device package architecture 100, or any other device package architectures shown herein. While FIGS. 7A-7H show elements of the sixth device package architecture 600, it is clear for the skilled person how to adapt the discussed method to manufacture other device packages described herein. FIG. 8 depicts an example embodiment of a process 800 for forming a device package assembly corresponding to the illustrative embodiment of FIGS. 7A-7H.

FIG. 7A depicts S810 in the process of FIG. 8 where the core substrate 103 is prepared. The core substrate 103 may be formed of glass or a semiconductor such as silicon, or a combination thereof. In some embodiments, the core substrate 103 may have the one or more through-vias formed within, the one or more TSVs 116 extending between a first side and a second side of the core substrate 103. In some embodiments, the one or more TSVs 116 may be formed using drilling, laser milling, etching, or any other suitable process, and combinations thereof. In some embodiments, the one or more TSVs 116 may include a conductive material formed within the one or more TSVs 116, such as a metal plug, and may include materials such as copper, aluminum, titanium, tungsten, and combinations thereof. In some embodiments, the conductive material may be formed by a physical vapor deposition (PVD) process, a chemical vapor deposition (CVD) process, an atomic layer deposition (ALD) process, electrowetting, electroplating, or any other suitable technique. In some embodiments, one or more materials may be deposited to form a liner layer prior to bulk deposition, while in other embodiments, the conductor may be deposited directly on the core substrate 103.

In some embodiments, the one or more heat conduits 144, the one or more fluid cooling channels 142, or a combination thereof may be formed in the core substrate 103 during the preparation of the core substrate 103 at S810. In some embodiments, the one or more heat conduits 144, the one or more fluid cooling channels 142, or a combination thereof may be formed by first forming one or more openings within the core substrate 103, the openings may be formed using drilling, laser milling, etching, or any other suitable process, and combinations thereof. In some embodiments, the one or more heat conduits 144, the one or more fluid cooling channels 142, or a combination thereof may then be partially or completely filled using a thermal conductive material such as one or more layers of metals, carbides or nitrides. In some embodiments, the one or more fluid cooling channels 142 may be partially formed within the core substrate 103, and may include one or more parts formed on the core substrate 103. For example, an open channel may be formed within the core substrate 103, with a lid mounted upon the supporting substrate 101 to cover the open channel. In other embodiments, any suitable technique may be used to form the one or more fluid cooling channels 142 within the supporting substrate 101. In some embodiments, the one or more heat conduits 144 may be formed to a specified depth within the core substrate 103 to couple with embedded devices, while in other embodiments, the depth may be larger or smaller. In some embodiments, the one or more heat conduits 144 and the one or more fluid cooling channels 142 may be formed within the same layer of the core substrate 103. In other embodiments the one or more fluid cooling channels 142 may be formed above or below the one or more heat conduits 144.

FIG. 7B depicts S820 in the process of FIG. 8 where one or more cavities 701 are formed in the supporting substrate 101. In some embodiments, the one or more cavities 701 may be formed using a variety of techniques, such as laser milling, drilling, etching, or any other suitable process either alone or in combination. In some embodiments, the one or more cavities 701 may be formed to a depth intersecting the one or more heat conduits 144, while in other embodiments, the depth may be larger or smaller. In some embodiments, the one or more cavities 701 may be formed to a uniform depth, while in other embodiments, the one or more cavities 701 may vary in depth within each cavity, between each cavity, or a combination thereof. In some embodiments, the one or more cavities 701 may be formed to a depth such that the first PIC 108 or the connecting element 350 may be mounted within a corresponding cavity such that a surface of the first PIC 108 or the connecting element 350 may be coplanar with a surface of the core substrate 103, while in other embodiments, the surface of the first PIC 108 or the connecting element 350 may be above or below a corresponding surface of the core substrate 103.

FIG. 7C depicts S830 in the process of FIG. 8 where the attachment layer 109 is deposited within the one or more cavities 701. In some embodiments, the attachment layer 109 may be formed from an adhesive material such as a resin or epoxy, a metal layer, a dielectric material, and any other suitable material to form one or more layers to allow the first PIC 108 or the connecting element 350 to attach to the core substrate 103. In some embodiments, the attachment layer 109 may formed using a process such as CVD, PVD, ALD, or any other suitable process. In some embodiments, the attachment layer 109 may be the same material in each of the one or more cavities 701, while in other embodiments, the material of the attachment layer 109 may vary between the one or more cavities 701. In some embodiments, the attachment layer 109 may be formed to a uniform depth in each of the one or more cavities 701, while in some embodiments, the depth may vary within each of the one or more cavities 701, or the depth may vary between each of the one or more cavities 701.

FIG. 7D depicts S840 in the process of FIG. 8 where the first PIC 108 and the connecting element 350 are mounted on the attachment layer 109 within the one or more cavities 701. In some embodiments, the first PIC 108 and the connecting element 350 may be mounted such that a surface of the first PIC 108 or the connecting element 350 may be coplanar with a surface of the core substrate 103, while in other embodiments, the surface of the first PIC 108 or the connecting element 350 may be above or below a corresponding surface of the core substrate 103. In some embodiments, the connecting element 350 may comprise a logic circuit, while in other embodiments the connecting element 350 may be formed using a semiconductor substrate, such as a silicon die. In some embodiments, the first PIC 108 or the connecting element 350 may have the attachment layer 109 form a bond between the first PIC 108 or the connecting element 350 and the core substrate 103. In some embodiments, the supporting substrate 101 may be further treated to bond the first PIC 108 or the connecting element 350 to the core substrate 103, and may include the use of thermal energy or radiation energy to form a bond, such as by curing an epoxy or resin within the attachment layer 109.

FIG. 7E depicts S850 in the process of FIG. 8 where the upper RDL 112 and the lower RDL 114 are formed on the core substrate 103. The upper RDL 112 and the lower RDL 114 may include one or more layers including a series of pads, bumps, vias, through-vias, traces, and other forms of connection for redistributing signals. In some embodiments, the upper RDL 112 and the lower RDL 114 may be formed directly on a surface of the core substrate 103, while in some embodiments one or more build up layers may be formed to create a planar surface which the upper RDL 112 and the lower RDL 114 may be formed upon. In some embodiments, the buildup layer may include one or more materials including molding compounds, resins, epoxies, dielectric material, and other suitable materials for use with the core substrate 103. In some embodiments, the upper RDL 112 may be formed over the one or more cavities 701, and may be coupled to the first PIC 108 and the connecting element 350. In some embodiments, the upper RDL 112 and the lower RDL 114 may be formed using a variety of techniques to form and pattern conductive layers, including the deposition of one or more materials using PVD, CVD, ALD, or other suitable techniques. The materials may be further patterned using techniques such as lithography, etching, grinding, milling, ablation, to selectively remove potions of the materials, while in other embodiments, techniques such as using a photoresist mask may be used to selectively deposit materials. In some embodiments, the materials may include conductive materials such as metals, as well as dielectric materials such as nitrides and oxides. In some embodiments, the upper RDL 112 and the lower RDL 114 may be formed in parallel, while in other embodiments, the upper RDL 112 and the lower RDL 114 may be formed sequentially, or in a combination of parallel and sequential steps.

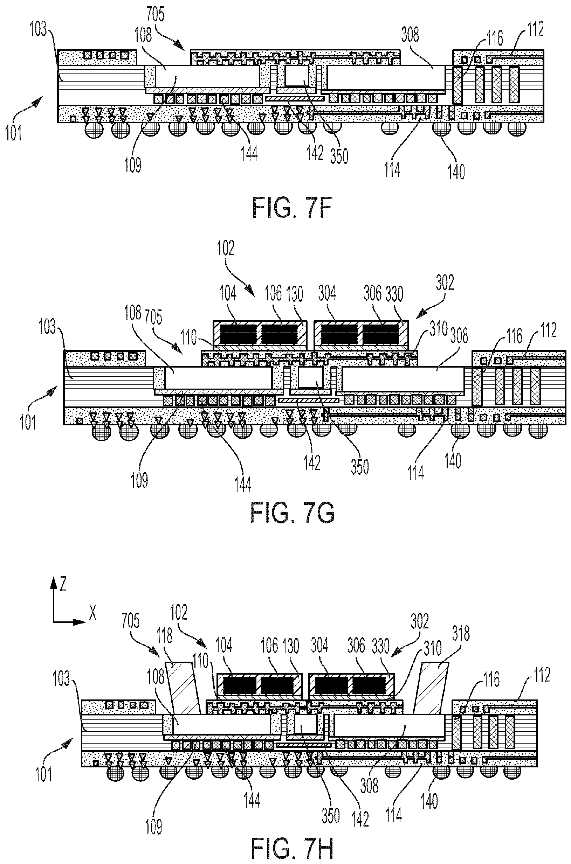

FIG. 7F depicts S860 in the process of FIG. 8 where an open space 705 may be formed in the upper RDL 112 over the first PIC 108. In some embodiments, the open space 705 may be formed using a method such as lithography, etching, milling or any other suitable method to remove a portion of material in the upper RDL 112. In some embodiments, the open space 705 may be formed during the formation of the upper RDL 112 at S850, while in other embodiments, the open space 705 may be formed after the upper RDL 112 is formed. In some embodiments, the open space 705 may expose a top surface of the first PIC 108, while in other embodiments, the open space 705 may expose a side surface or bottom surface of the first PIC 108. In some embodiments, the open space 705 may be formed to expose one or more additional optical elements embedded in the core substrate 103, for example a thin optical film, a filter, or a waveguide coupled to the first PIC 108.

Additionally, at S860, the substrate interconnection 140 may be formed upon the lower RDL 114. In some embodiments, the substrate interconnection 140 may include a conductive interconnection, a dielectric interconnection, or a hybrid interconnection. In some embodiments, a conductive interconnection may include pads, bumps, microbumps, pillars, balls, ball grids, microball arrays, and other forms such as C4 bumps, alone or in combination. In some embodiments, a dielectric interconnection may include a dielectric material such as silicon dioxide, resins, adhesives, and epoxies, alone or in combination. In some embodiments, the dielectric material may take the form of an underfill and be introduced between a card and the supporting substrate 101 in conjunction with a conductive interconnection, and may form a hybrid connection between the card and the supporting substrate 101. In some embodiments, the substrate interconnection 140 may electrically connect the supporting substrate 101 to further substrate such as an interposer, additional substrate, card, board, or some combination thereof. In some embodiments, the substrate interconnection 140 may be fully formed at 8860, mounting the supporting substrate 101 on the further substrate, while in other embodiments, the substrate interconnection 140 may be only partially formed at 8860, such as forming a conductive ball grid array suitable for later mounting of the supporting substrate 101 on the further substrate.

FIG. 7G depicts S870 in the process of FIG. 8 where the first multi-device package 102 and the second multi-device package 302 may be mounted on the supporting substrate 101, upon the upper RDL 112. In some embodiments, the first multi-device package 102 and the second multi-device package 302 may be mounted upon the upper RDL 112 using one or more conductive connections and one or more dielectric bonds. The one or more conductive connections may include pads, bumps, microbumps, pillars, balls, ball grids, microball arrays, and other forms such as C4 bumps, alone or in combination. The one or more dielectric bonds may include a dielectric material or adhesive between the first multi-device package 102 or the second multi-device package 302 and the upper RDL 112, such as an epoxy, a resin, or other suitable material. In some embodiments, the one or more dielectric bonds may be formed using an underfill technique and inserted between the first multi-device package 102 or the second multi-device package 302 and the upper RDL 112 and around the one or more conductive connections. In some embodiments, the one or more conductive connections and the one or more dielectric bonds may combine to form a hybrid bond between the first multi-device package 102 or the second multi-device package 302 and the supporting substrate 101.

FIG. 7H depicts S880 in the process of FIG. 8 where the first optical connection 118 is coupled to the first PIC 108 using the open space 705 within the upper RDL 112. In some embodiments, the first optical connection 118 may take the form of an optical connector, a FAU, a pluggable optical connector, a plug connector, a v-groove, as well as combinations thereof and various arrays thereof. In some embodiments, additional optical elements may be placed between the first optical connection 118 and the first PIC 108, such as polarizers, gratings, anti-reflection coatings, filters, index matching coatings, lenses, and any other suitable optical components, alone or in a combination thereof. In some embodiments, the first optical connection 118 may be permanently attached to the first PIC 108, while in other embodiments the first optical connection 118 may be removably attached to the first PIC 108. Similarly, the second optical connection 318 may be coupled to the second PIC 308.

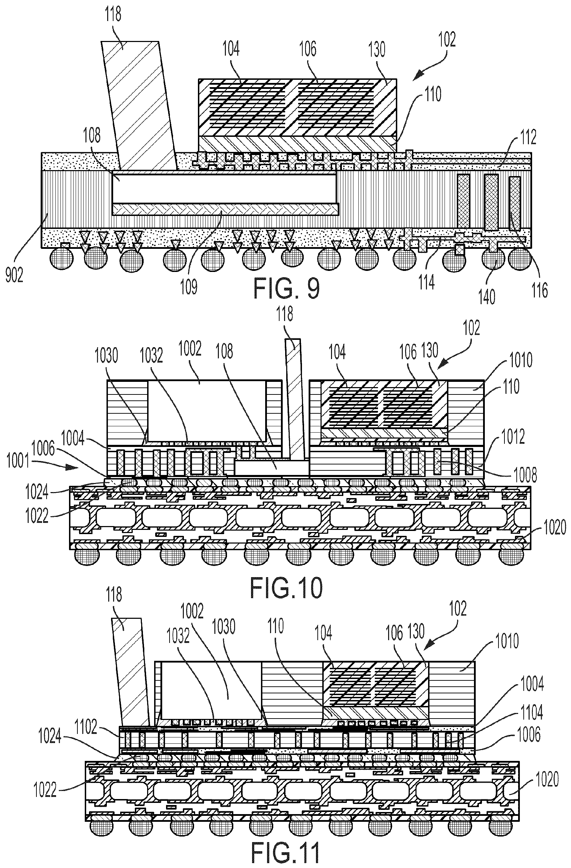

FIG. 9 depicts a cross-section view of an example embodiment of a seventh device package architecture 900, the seventh device package architecture 900 differing from the first device package architecture 100 of FIG. 1A by replacing the core substrate 103 with an organic substrate 902. Furthermore, the seventh device package architecture 900, being an organic substrate, may lack the one or more fluid cooling channels 142 and the one or more heat conduits 144 of the first device package architecture 100. The organic substrate 902 may include one or more layers of organic materials, including polymers.

FIG. 10 depicts a cross-section view of an example embodiment of an eighth device package architecture 1000, the eighth device package architecture 1000 differing from the first device package architecture 100 of FIG. 1A by shifting the first PIC 108 from the supporting substrate 101 to an RDL interposer 1001. The first PIC 108 may between a first interposer RDL 1004 and a second interposer RDL 1006. The first interposer RDL 1004 may couple the first multi-device package 102 to the first PIC 108. One or more pillars 1008 may couple the first interposer RDL 1004 and the second interposer RDL 1006. The one or more pillars 1008 may be a conductive material, such as a metal like copper, with the one or more pillars separated by an interposer dielectric material 1012. The interposer dielectric material 1012 may provide thermal, electrical, and mechanical protection for the first PIC 108 and the one or more pillars 1008. In some embodiments, the interposer dielectric material 1012 may be formed of a semiconductor material such as silicon oxide, or may be formed from epoxy molding compound. Upon the RDL interposer 1001, a supplemental compute device 1002 may be mounted. The supplemental compute device 1002 may provide additional computation for the ninth device package architecture 1100 to allow the first multi-device package 102 to offload some functions. In some embodiments, the supplemental compute device 1002 may take the form of an ASIC. An upper encapsulation layer 1010 may be formed to encapsulate the first multi-device package 102, the supplemental compute device 1002, and the RDL interposer 1001. The supplemental compute device 1002 and the first multi-device package 102 may be mounted to the RDL interposer 1001 using one or more conductive interconnections 1032 such as a microball array, and a dielectric interconnect 1030, such as a molding compound. The first optical connection 118 may couple to the first PIC 108 between the supplemental compute device 1002 and the first multi-device package 102. The RDL interposer 1001 may be further mounted on to a supplemental substrate 1020, which in turn may be mounted to a card or board. The RDL interposer 1001 may include one or more substrate interconnectors 1022, which may take the form of a ball grid array, and may include a dielectric intermediate 1024, such as a molding compound.

FIG. 11 depicts a cross-section view of an example embodiment of a ninth device package architecture 1100, the ninth device package architecture 1100 differing from the eighth device package architecture 1000 by using a PIC interposer 1102 and shifting the first optical connection 118 to the edge. In place of the one or more pillars 1008, one or more through-PIC vias 1104 are formed to connect the first interposer RDL 1004 to the second interposer RDL 1006.

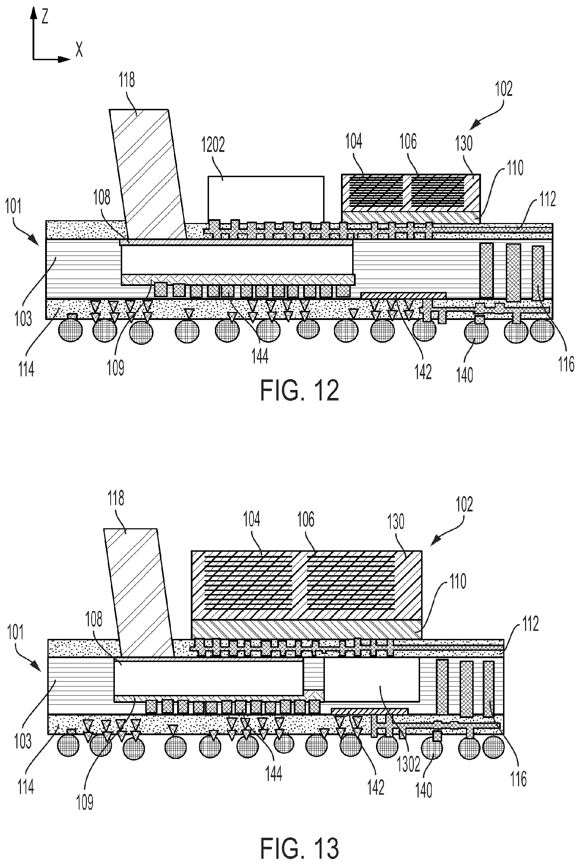

FIG. 12 depicts a cross-section view of an example embodiment of a tenth device package architecture 1200, the tenth device package architecture 1200 differing from the first device package architecture 100 of FIG. 1A by placing a separate mounted EIC 1202 on the supporting substrate 101. The separate mounted EIC 1202 may provide the electrical support to transmit and receive signals via the first PIC 108. The upper RDL 112 may couple the separate mounted EIC 1202 to both the first multi-device package 102 and the first PIC 108, with the separate mounted EIC 1202 being able to translate incoming optical signals from the first PIC 108 and transmit them to the first multi-device package 102, as well as to receive instructions from the first multi-device package 102 and input the instructions into the first PIC 108.

FIG. 13 depicts a cross-section view of an example embodiment of an eleventh device package architecture 1300, the eleventh device package architecture 1300 differing from the first device package architecture 100 of FIG. 1A by placing a separate embedded EIC 1302 on the supporting substrate 101. The separate embedded EIC 1302 may provide the electrical support to transmit and receive signals via the first PIC 108. The upper RDL 112 may couple the separate embedded EIC 1302 to both the first multi-device package 102 and the first PIC 108, with the separate embedded EIC 1302 being able to translate incoming optical signals from the first PIC 108 and transmit them to the first multi-device package 102, as well as to receive instructions from the first multi-device package 102 and input the instructions into the first PIC 108.

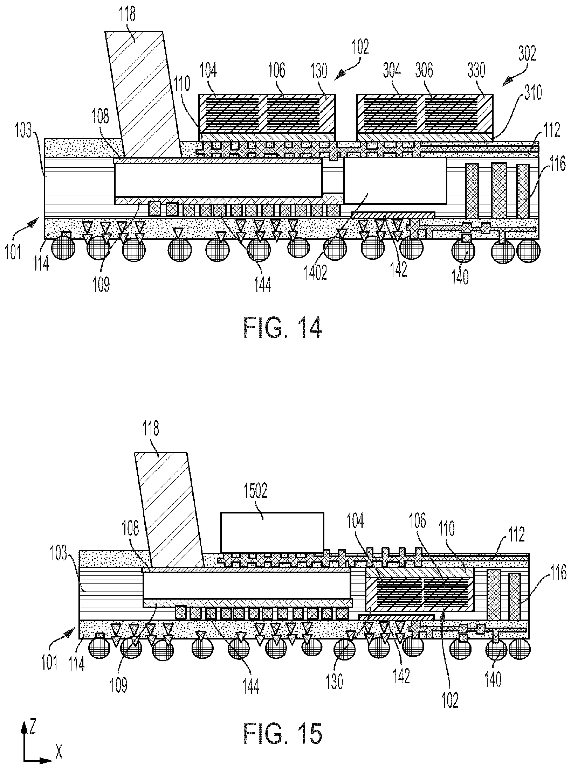

FIG. 14 depicts a cross-section view of an example embodiment of a twelfth device package architecture 1400, the twelfth device package architecture 1400 differing from the first device package architecture 100 of FIG. 1A by mounting both the first multi-device package 102 and the second multi-device package 302 with the first PIC 108. An embedded supplemental compute device 1402 is provided embedded within the supporting substrate 101 and coupled to the first PIC 108, the first multi-device package 102 and the second multi-device package 302 via the upper RDL 112. The embedded supplemental compute device 1402 may, in some embodiments, be an ASIC device.

FIG. 15 depicts a cross-section view of an example embodiment of a thirteenth device package architecture 1500, the thirteenth device package architecture 1500 differing from the first device package architecture 100 of FIG. 1A by embedding the first multi-device package 102 within the supporting substrate 101. The first multi-device package 102 may be mounted such that the support base 110 is adjacent to the upper RDL 112, in a flipped position from the first device package architecture 100. Furthermore, a mounted supplemental compute device 1502 is provided mounted on the supporting substrate 101 and coupled to the first PIC 108, the first multi-device package 102 and the second multi-device package 302 via the upper RDL 112. The mounted supplemental compute device 1502 may, in some embodiments, be an ASIC device.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A device comprising:
a substrate (101) having a first attachment location and a second attachment location;
a first photonic integrated circuit (108) positioned within the first attachment location;
a first connecting element (350; 551) positioned within the second attachment location; and
a first multi-device package (102) positioned on the substrate (101) and at least partially over the first attachment location and the second attachment location.

2. The device of claim 1, further comprising a second multi-device package (302) positioned on the substrate (101) at least partially over the second attachment location, wherein the second multi-device package (302) is electrically connected to the first multi-device package (102) by the first connecting element (350; 551).

3. The device of claim 1 or 2, wherein the first multi-device package (102) includes at least one selected from the group consisting of a memory device and a processing device.

4. The device of any one of claims 1 to 3, wherein a redistribution layer (112) is arranged between the first photonic integrated circuit (108) and the first multi-device package (102), and wherein an optical fiber connection extends between a surface of the substrate (101) and the first photonic integrated circuit (108).

5. The device of any one of claims 1 to 4, wherein the substrate (101) comprises at least one selected from a group consisting of glass and silicon.

6. The device of any one of claims 1 to 5, wherein the first photonic integrated circuit (108) includes a connector configured to receive a bi-directional optical fiber,
wherein the bi-directional optical fiber is configured to transmit an incoming optical signal to the first photonic integrated circuit (108), and
wherein the bi-directional optical fiber is configured to transmit an outgoing optical signal from the first photonic integrated circuit (108).

7. The device of any one of claims 1 to 6, further comprising:
a fluid cooling channel (142) formed within the substrate (101); and
a heat conduit (144) formed between the first attachment location and a surface of the substrate (101),
wherein the heat conduit (144) thermally couples the first photonic integrated circuit (108) to the fluid cooling channel (142).

8. The device of any one of claims 1 to 7, further comprising an electronic integrated circuit (202) arranged between the first photonic integrated circuit (108) and the substrate (101).

9. The device of any one of claims 1 to 8, wherein:
the substrate (101) has a first side and a second side opposite the first side, the first side having the first attachment location and the second attachment location,
the first multi-device package (102) is positioned on the first side of the substrate (101), and
the device further comprises a first heat conduit (144) within the substrate (101), the first heat conduit (144) extending from the second side to the first attachment location.

10. The device of claim 9, further comprising a second multi-device package (302) positioned on the first side of the substrate (101),
wherein the second multi-device package (302) is coupled to the first multi-device package (102) via the first connecting element (350; 551) with the first connecting element (350; 551) at least partially within the second attachment location.

11. The device of claim 9 or 10, further comprising:
a first attachment layer (109) between the first heat conduit (144) and the photonic integrated circuit (108); and/or
a second heat conduit within the substrate (101), wherein the second heat conduit extends from the second side to the second attachment location; and a second attachment layer between the second heat conduit and the first connecting element (350; 551); and/or
a fluid cooling channel (142) within the substrate (101) and thermally coupled to the first heat conduit (144).

12. The device of any one of claims 9 to 11, further comprising a redistribution layer (112) arranged between the photonic integrated circuit (108) and the first multi-device package (102); and
an optical fiber connection extending between a surface of the first side of the substrate (101) and a surface of the photonic integrated circuit (108) parallel to the first side.

13. A method comprising:
forming a first attachment location and a second attachment location within a first side of a substrate (101);
positioning a photonic integrated circuit (108) at least partially within the first attachment location;
positioning a first connecting element (350; 551) at least partially within the second attachment location;
forming a redistribution layer (112) on the first side of the substrate (101);
forming an opening in the redistribution layer (112) over the photonic integrated circuit (108);
positioning a first multi-device package (102) on the redistribution layer , the first multi-device package (102) electrically connected to the photonic integrated circuit (108) and the first connecting element (350; 551);
positioning a second multi-device package (302) on the redistribution layer (112), the second multi-device package (302) electrically connected to the first multi-device package (102) via the first connecting element (350; 551); and
connecting an optical fiber to the photonic integrated circuit (108) via the opening in the redistribution layer (112).

14. The method of claim 13, further comprising preparing the substrate (101) including at least one of forming a heat conduit, forming a liquid cooling channel and forming a through-substrate via.

15. The method of claim 13 or 14, wherein the optical fiber connects to a surface of the photonic integrated circuit (108) parallel to the first side of the substrate (101), and/or
wherein the first multi-device package (102) comprises at least one of a processing device and a memory device, and/or
wherein forming the first attachment location and the second attachment location within the first side of the substrate (101) comprises laser milling a glass substrate.
